# EUROPEAN PATENT APPLICATION

(11) **EP 1 098 373 A2**
(43) Date of publication of application: **09.05.2001**
(21) Application number: 00309768.0
(22) Date of filing: 03.11.2000
(51) Int. Cl.: H01L 33/00, H01L 25/075, H01L 27/15

(54) **A semiconductor light source**

(30) Priority: 03.11.1999 GB 9926091
(71) Applicant: Page Aerospace Limited, Sunbury-on-Thames, Middlesex TW16 6EQ (GB)
(72) Inventor: Gibbs, Paul Richard, Chertsey, Surrey KT16 9PA (GB)
(74) Representative: Foster, David Martyn

(57) **Abstract**

A semiconductor light source, comprising a transparent housing (6) incorporating a lens (10), a semiconductor substrate (4) contained in the housing, and a plurality of connecting leads (8) which pass into the housing (6) and form electrical connections to the substrate (4), the substrate (4) being curved or otherwise configured and having a plurality of light emitting diodes (2) formed thereon which are electrically interconnected with the connecting leads (8) such that each of the light emitting diodes (2) is separately operable to emit light by causing current to flow in at least one pair of the connecting leads (8). The light source provides a consistent light intensity and direction.

## Description

This invention relates to a semiconductor light source for use particularly, though not exclusively, in the aircraft industry. Such light sources may for example be used in light fittings for passenger reading lights or the like.

EP049385.0 shows that it is known to provide several light emitting diodes (LEDs) on a common substrate with connection leads between them. These LEDs can be used sequentially in order to maintain light intensity despite ageing of individual LEDs. The invention aims to improve the consistency of light intensity and direction and to provide improvement to the control of the LEDs.

In accordance with the invention, there is provided a semiconductor light source, comprising a transparent housing incorporating a lens, a semiconductor substrate contained in the housing, a plurality of light emitting diodes (LEDs) formed on the substrate, and electrical connecting means extending to the substrate from externally of the housing and enabling each of the LEDs to be separately operable to emit light, characterised in that the substrate defines a curve and the LEDs are arranged on that curve to present light through the lens.

According to the invention, there is also provided a semiconductor light source, comprising a transparent housing incorporating a lens, a semiconductor substrate contained in the housing, a plurality of light emitting diodes (LEDs) formed on the substrate, and electrical connecting means extending to the substrate from externally of the housing and enabling each of the LEDs to be separately operable to emit light, characterised by means tending to equalise the direction and intensity of light emitted from the housing by different ones of the LEDs.

According to the invention, there is further provided a semiconductor light source, comprising a transparent housing incorporating a lens, a semiconductor substrate contained in the housing, and a plurality of connecting leads which pass into the housing and form electrical connections to the substrate, the substrate having a plurality of light emitting diodes (LEDs) formed thereon which are electrically interconnected with the connecting leads such that each of the LEDs is separately operable to emit light by causing current to flow in at least one pair of the connecting leads, characterised in that the LEDs are arranged in one or more pairs, the LEDs of the or each pair being connected in parallel so that the anode of one LED is coupled to the cathode of the other LED and vice versa, whereby current passed in one direction through the pair causes one of the diodes of the pair to emit light and current passed through the pair in the opposite direction causes the other diode of the pair to emit light.

Semiconductor light sources embodying the invention will now be described by way of example with reference to the drawings in which:
Figure 1 is a cross-section of a semiconductor light source for explaining the function of the invention;
Figure 2 is a cross-section of an alternative semiconductor light source in accordance with the invention; and
Figure 3 is a schematic plan view of a semiconductor light source in accordance with the invention showing possible interconnections for the LEDs.

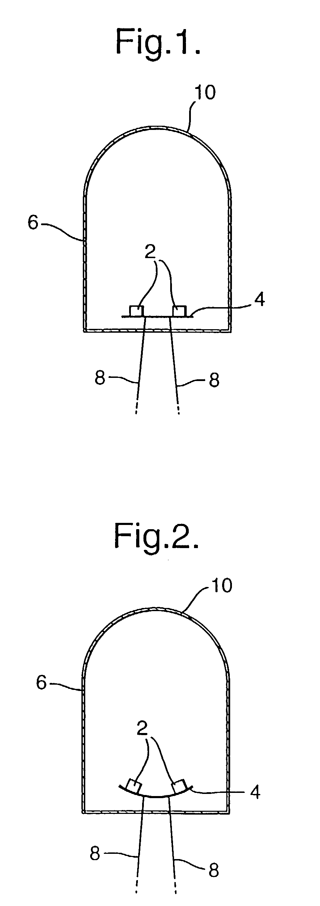

With reference to Figure 1, a light source is illustrated with a plurality of light emitting diodes (LEDs) 2 formed on a substrate 4. The substrate 4 and LEDs 2 are mounted within a generally transparent plastics housing 6.

Connecting leads 8 pass through the housing 6 and make electrical connections with the substrate 4. Typically also, the connecting leads 8 serve to support the substrate 4 within the housing 6.

The upper part of the housing 6 is formed into a lens 10 to focus light emitted by the LEDs 2.

In a conventional LED package, only a single LED is housed in the housing 6. It is known that LEDs have a limited operating life. Typically, for example, the brightness of an LED diminishes to 80% of its initial brightness after 2000 hours of operation. This is undesirable, for example, in the aircraft industry where a light may be required to operate within a specific brightness specification. In order to extend the operating life of a semiconductor light source, therefore, several LEDs within a single housing 6 may be used. These LEDs may be arranged in subsets (including individually) to allow current to flow in various combinations of the connecting leads 8 in order to illuminate one or more of them.

In Figure 2, an embodiment of the present invention is depicted in which the LEDs 2 are mounted in a generally curved configuration. This configuration is used to minimise changes in the direction and intensity of light emitted from the lens 10 as different subsets of LEDs 2 are illuminated. A curved configuration also reduces packaging dimensions.

The subsets of LEDs 2 within the housing 6 may be switched over a very long time period (several hours for example) or may be switched at a relatively high frequency (sufficiently high that variations in light intensity due to the switching are not discernible by the human eye).

The LEDs 2 within the housing 6 are packed closely together on the substrates (for example using a generally hexagonal shape to permit high densities). As the LEDs 2 are switched and depending on the characteristics of the lens 10, the direction and intensity of the light emitted from the lens 10 may vary depending on which subsets the LEDs 2 are illuminated at any given time. To overcome this problem, the lens 10 may have multiple foci by manufacturing the lens 10 as a Fresnel lens and/or by forming lens 10 with one or more aspherical lenses.

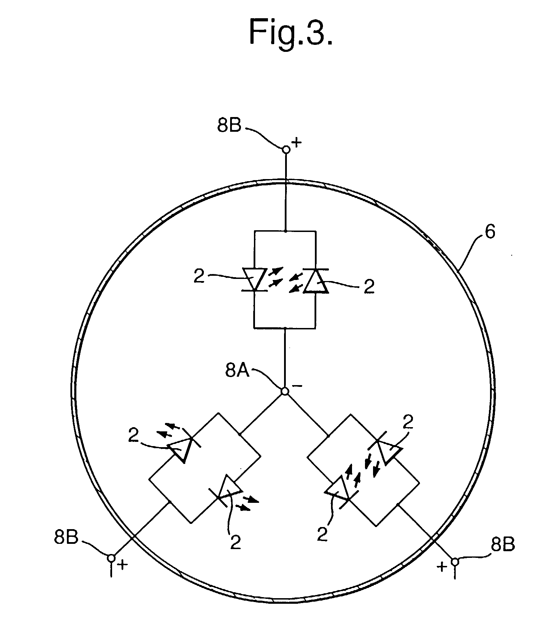

Figure 3 shows one possibility for interconnecting the LEDs within the housing 6. As will be seen, the LEDs 2 are interconnected in parallel pairs with the anode of one LED 2 of each pair connected to the cathode of the other pair. Furthermore, one end of the parallel pairs is connected in each case to a common connecting lead 8A and the other ends of the pairs are connected to connecting leads 8B. Using this interconnection scheme, it is possible to illuminate a single LED within each pair depending on the polarity of current passed between the connecting lead 8A and the respective connecting leads 8B. This arrangement is highly efficient in terms of the number of connecting leads required to control individual LEDs within the housing 6. In this case, any one of six LEDs may be controlled using only three connecting leads. In general, n connecting leads allows 2(n-1) LEDs to be controlled using this configuration of parallel-connected pairs LEDs.

Other connection configurations are possible as will be appreciated by the skilled person.

Preferably, the invention includes a control circuit operable to switch automatically the LEDs in the housing 6 to achieve subjectively invariant light intensity whilst maximising the operating life of the light source. Such control circuitry may be contained within the housing and more preferably, may be formed on the same substrate as the LEDs. This not only avoids the need to provide separate control circuitry but may also be used to reduce the number of connecting leads. The control circuitry may, for example, need only connections to a power supply and a current-limiting resistor.

The housing 6 may also include a light-sensitive transducer (not shown) which is arranged to sense the brightness of one or more of the LEDs 2. The output of the transducer may be used by the control circuitry to change the order and/or sequence of switching of the LEDs to ensure that the overall brightness of the light source is within a predetermined range.

One or more of the LEDs 2 may also be arranged to radiate at a relatively high energy wavelength (such as at ultraviolet wavelengths) and to irradiate a material such as a fluorescent material that is arranged to re-radiate the energy in the visible spectrum (for example, as white light).

## Claims

1. A semiconductor light source, comprising a transparent housing (6) incorporating a lens (10), a semiconductor substrate (4) contained in the housing (6), a plurality of light emitting diodes (LEDs) (2) formed on the substrate (4), and electrical connecting means (8) extending to the substrate (4) from externally of the housing (6) and enabling each of the LEDs (2) to be separately operable to emit light, characterised in that the substrate (4) defines a curve and the LEDs (2) are arranged on that curve to present light through the lens (10).

2. A light source according to claim 1, characterised in that the lens (10) has a single focal point and the radius of the curve is such that each LED (2) is generally the same radial distance from a predetermined point on the focal axis of the lens (10) and such that the direction and intensity of light emitted from the housing (6) is generally the same for light emitted from different ones of the light emitting diodes (2).

3. A semiconductor light source, comprising a transparent housing (6) incorporating a lens (10), a semiconductor substrate (4) contained in the housing (6), a plurality of light emitting diodes (LEDs) (2) formed on the substrate (4), and electrical connecting means (8) extending to the substrate (4) from externally of the housing (6) and enabling each of the LEDs (2) to be separately operable to emit light, characterised by means tending to equalise the direction and intensity of light emitted from the housing (6) by different ones of the LEDs (2).

4. A light source according to claim 2, characterised in that the equalising means comprises the lens (10) which is arranged to have multiple focal points.

5. A light source according to claim 4, characterised in that the lens (10) is a fresnel lens.

6. A light source according to claim 4 or claim 5, characterised in that the lens (10) is aspherical.

7. A light source according to any one of claims 3 to 6, characterised in that the substrate (9) defines a curve and the LEDs (2) are arranged on that curve to present light through the lens (10).

8. A light source according to any preceding claim, characterised in that the housing (6) incorporates a light emitting material which is generally absorbent of light energy at the wavelength of the energy radiated by the LEDs (2) such as ultraviolet light, and which re-radiates that energy as light of a different wavelength such as visible white light, when irradiated by light from the LEDs (2).

9. A light source according to any preceding claim, characterised in that the connecting means (8) includes a plurality of connecting leads (8) which pass into the housing (6) and for electrical connections to the LEDs (2) such that each LED (2) is separately operable to emit the light by causing current to flow in at least one pair of the connecting leads (8).

10. A light source according to claim 9, characterised in that the LEDs (2) are arranged in one or more pairs, the LEDs (2) of the or each pair being connected in parallel so that the anode of one LED (2) is coupled to the cathode of the other LED (2) and vice versa, whereby current passed in one direction through the pair causes one of the diodes (2) of the pair to emit light and current passed through the pair in the opposite direction causes the other diode (2) of the pair to emit light.

11. A light source according to claim 10, characterised in that there is a plurality of the pairs, each pair being coupled at one end to a common one of the connecting leads (8).

12. A semiconductor light source, comprising a transparent housing (6) incorporating a lens (10), a semiconductor substrate (4) contained in the housing (6), and a plurality of connecting leads (8) which pass into the housing (6) and form electrical connections to the substrate (4), the substrate (4) having a plurality of light emitting diodes (LEDs) (2) formed thereon which are electrically interconnected with the connecting leads (8) such that each of the LEDs (2) is separately operable to emit light by causing current to flow in at least one pair of the connecting leads (8), characterised in that the LEDs (2) are arranged in one or more pairs, the LEDs of the or each pair being connected in parallel so that the anode of one LED (2) is coupled to the cathode of the other LED (2) and vice versa, whereby current passed in one direction through the pair causes one of the diodes (2) of the pair to emit light and current passed through the pair in the opposite direction causes the other diode (2) of the pair to emit light.

13. A light source according to claim 12, characterised in that it includes a plurality of the pairs, each pair being coupled at one end to a common one of the connecting leads (8).

14. A light source according to any preceding claim, characterised by control means for energising the LEDs (2) in separate groups each comprising one or more respective ones of the LEDs (2).

15. A light source according to any preceding claim, characterised in that by a light sensitive transducer operable to monitor the brightness of one or more of the LEDs (2).

16. A control circuit couplable to the connecting means or connecting leads of a light source according to any preceding claim, characterised in that it is arranged to supply current to the LEDs (2) to cause each LED (2) to emit light in a predetermined sequence with a predetermined duration of illumination for each LED (2) and such that the light source appears to provide generally continuous light output of a generally constant intensity.

17. A control circuit light source according to claim 16, characterised in that it is located within the housing (6).

18. A control circuit light source according to claim 17, characterised in that it is formed integrally on the substrate (4).

19. A light for the passenger compartment of an aircraft, characterised in that it includes a plurality of the light sources of any preceding claim.

20. A light for the passenger compartment of an aircraft, characterised in that it includes a control circuit according to anyone of claims 16 to 18.
